# EUROPÄISCHE PATENTSCHRIFT

(11) **EP 2 752 281 B1**
(45) Veröffentlichungstag und Bekanntmachung des Hinweises auf die Patenterteilung: **31.05.2017**
(21) Anmeldenummer: 14150326.8
(22) Anmeldetag: 07.01.2014
(51) Int. Cl.: B29C 33/02, B29C 41/46, B29C 33/38, C25D 1/10

(54) **BEHEIZBARES FORMWERKZEUG, INSBESONDERE BEHEIZBARES GALVANISCH ABGESCHIEDENES FORMWERKZEUG, SOWIE EIN VERFAHREN ZUR HERSTELLUNG DES FORMWERKZEUGS**
HEATABLE MOULDING TOOL, IN PARTICULAR HEATABLE GALVANICALLY DEPOSITED MOULDING TOOL, AND A METHOD FOR PRODUCING THE MOULDING TOOL
OUTIL DE FORMAGE CHAUFFANT, NOTAMMENT OUTIL DE FORMAGE CHAUFFANT DÉPOSÉ PAR ÉLECTROLYSE, ET PROCÉDÉ DE FABRICATION DE L'OUTIL DE FORMAGE

(30) Priorität: 07.01.2013 DE 202013000039 U; 20.03.2013 DE 102013004764
(43) Veröffentlichungstag der Anmeldung: 09.07.2014
(73) Patentinhaber: Antolin Straubing GmbH, 94315 Straubing (DE)
(72) Erfinder: Wolf, Ludwig, 94369 Rain (DE)
(74) Vertreter: Capitán García, Maria Nuria

(56) Entgegenhaltungen:
- WO-A1-2011/035376
- WO-A1-2012/172094
- DE-A1- 4 122 995
- DE-B3-102011 112 805
- JP-A- H04 220 310
- JP-A- H05 116 182
- JP-A- 2007 044 897
- BASCHE M ET AL: "New Pyrolytic Boron Nitride in Bulk Form", ENGINEERS' DIGEST,, Bd. 25, Nr. 4, 1. April 1964 (1964-04-01), Seiten 93-94, XP001263606,
- OLSON R: "PARYLENE CONFORM COATING AND ITS APPLICATION FOR ELECTRONICS", PROCEEDINGS INTERNATIONAL ELECTRONICS PACKAGING CONFERENCE, XX, XX, vol. 1, 27 September 1992 (1992-09-27), pages 112-117, XP001041079,

## Beschreibung

Die vorliegende Erfindung betrifft ein Formwerkzeug, insbesondere ein galvanisch abgeschiedenes Formwerkzeug mit integrierter elektrischer Flächenheizung, sowie ein Verfahren zur Herstellung des Formwerkzeugs.

In der Automobilindustrie werden mit galvanisch abgeschiedenen Formwerkzeugen Oberflächenteile mit ansprechender Geometrie, wie zum Beispiel Instrumententafeln, Mittelkonsolen Türverkleidungen aus thermoplastischen Materialien hergestellt. Ein übliches Herstellverfahren ist hierbei das Rotationssinterverfahren, bei dem die thermoplastischen Kunststoffmaterialien in Form eines Pulvers oder Granulates in das Formwerkzeug eingebracht und an der Oberfläche der Werkzeugformen aufgeschmolzen werden. Um ein gleichmäßiges Aufschmelzen des Pulvers oder Granulates an der Oberfläche zu erzielen, müssen die Formwerkzeuge in mehreren Stufen auf sehr hohe Temperaturen aufgeheizt werden. Nach dem Aufschmelzen des Kunststoffmaterials werden die Formwerkzeuge abgekühlt und das fertige Oberflächenteil kann aus dem Formwerkzeug entnommen werden. Das Rotationssinterverfahren und die hierbei verwendeten Materialien sind dem Fachmann hinreichend bekannt und werden an dieser Stelle nicht näher beschrieben.

Das Aufheizen der Galvanoformen auf die erforderlichen hohen Temperaturen erfolgt üblicherweise mit Heißluft, mit vorgewärmtem Sand, mit heißem Öl, mit Gas, mit Infrarotbestrahlung oder mit einer Kombination mehrerer Verfahren. Die gleichmäßige Erwärmung der galvanischen Formwerkzeuge für den thermoplastischen Sinterprozess wird über eine entsprechend lange Taktzeit (Aufheizen und Egalisieren) erreicht. Hierbei sind meist mehrere Prozessstufen und somit eine Vielzahl von Stationen und separaten Heizstationen erforderlich. Insgesamt ist, aufgrund der indirekten Erwärmung der Galvanoformen, ein hoher Energiebedarf zum gleichmäßigem Aufheizen notwendig. Die japanische Patentanmeldung JP H 04 220 310 zeigt eine beheizbare Form die geeignet für ein Rotationssinterverfahren ist, wobei die rohrförmige Heizung zwischen zwei galvanisch abgeschiedenen Schichten eingebettet ist.

Die internationale Patentanmeldung WO 2012/172094 A1 zeigt eine integrierte Flächenheizung die vorzugsweise für Spritzgusswerkzeuge verwendet wird.

Aufgabe der vorliegenden Erfindung ist es ein Formwerkzeug für ein Sinterverfahren, insbesondere ein Rotationssinterverfahren bereitzustellen, bei dem ein gleichmäßiges Aufheizen mit hohem Wirkungsgrad möglich ist, die Standzeit des Formwerkzeugs hoch und wobei die Kosten der gesamten Anlage zum Aufheizen gering sind.

Diese Aufgabe wird durch die im Anspruch 1 angegebenen Merkmal Unter einem weiteren Aspekt wird ein Verfahren zur Herstellung eines Formwerkzeugs angegeben.

Das erfindungsgemäße Formwerkzeug mit integrierter elektrischer Flächenheizung ermöglicht ein direktes und gleichmäßiges Aufheizen des Formwerkzeuges mit hohem Wirkungsgrad und einfacher Anlagentechnologie. Die Kosten für die Anlage können erheblich reduziert werden, da keine zusätzlichen Aufheizstationen und zusätzliche Öfen für ein mehrstufiges Aufheizen erforderlich sind. Durch die direkte Erwärmung über die im Formwerkzeug integriert angeordnete elektrische Flächenheizung kann eine ständige Temperaturnachführung während des Rotationssinterverfahrens erfolgen.

Durch die gleichmäßige Erwärmung des Formwerkzeuges werden Materialspannungen innerhalb des Werkzeuges während der Aufheizphase verringert. Aufgrund der geringeren dynamischen und statischen Belastungen kann die Wandstärke der Form dünner ausgelegt werden. Auch der erfindungsgemäße Schichtaufbau der eine stabile Ausgestaltung des Formwerkzeugs erzielt, ermöglicht eine Ausführung des Formwerkzeugs mit einer dünnen Wandung, wobei die Schichtdicke zwischen 0,8 mm bis 3 mm ist. Dies hat zur Folge, dass zum Aufheizen und Abkühlen des Werkzeuges weniger Energie notwendig ist.

Insgesamt wird durch die gleichmäßige Erwärmung die Standzeit der Formwerkzeuge erhöht. Durch die luftdichte Kapselung der elektrischen Flächenheizung zwischen den Metalldeckschichten kann das Formwerkzeug mit sehr hohen Temperaturen aufgeheizt werden.

Der Anwendungsbereich ist jedoch nicht nur auf galvanisch hergestellte Formwerkzeuge für die Automobilindustrie beschränkt, sondern betrifft auch Galvanoformen im Allgemeinen.

Weitere vorteilhafte Ausgestaltungen und Weiterbildungen des erfindungsgemäßen Formwerkzeugs ergeben sich aus den Unteransprüchen.

Bevorzugte Ausführungsformen des Formwerkzeugs werden nachfolgend beispielshalber beschrieben, wobei veranschaulichend auf die beigefügten Zeichnungen Bezug genommen wird.

Es zeigt:

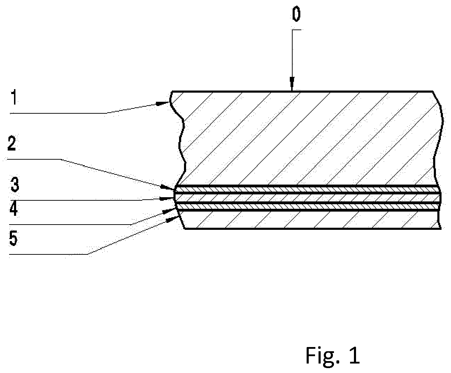

- Fig. 1: einen Querschnitt durch ein erfindungsgemäßes Formwerkzeug

Figur 1 zeigt einen Querschnitt durch das erfindungsgemäße Formwerkzeug. Dieses Formwerkzeug ist die Negativform des herzustellenden Kunststoff-Formteiles bzw. Oberflächenteils. Das erfindungsgemäße Formwerkzeug ist ein Bestandteil einer Sinteranlage. Üblicherweise wird das Formwerkzeug in einer Rotationssinteranlage eingesetzt. Diese nicht dargestellte Rotationssinteranlage umfasst im Wesentlichen das beheizbare Formwerkzeug 1 sowie einen Pulverbehälter, in dem ein Kunststoffpulver oder Kunststoffgranulat enthalten ist. Üblicherweise werden als Kunststoffe thermoplastische Kunststoffe wie Polypropylen, Polyurethan, Polyvinylchlorid verwendet.

Der Pulverbehälter deckt bei dem Herstellverfahren die zu beschichtende Formwerkzeugoberfläche ab und ist, wie bereits obenstehend erläutert mit dem Kunststoffpulver oder Kunststoffgranulat bestückt. Beim Rotieren der Rotationssinteranlage fällt das Kunststoffgranulat auf die beheizte Formwerkzeugoberfläche, wird dort aufgeschmolzen und als Kunststoffformhaut (Oberflächenteil) abgeschieden. Die Seite der Formwerkzeugoberfläche des Formwerkzeugs ist in der Figur 1 mit einem O bezeichnet.

Der Aufbau des Formwerkzeuges mit integrierter elektrischer Flächenheizung ist in der Schnittdarstellung in einem Ausschnitt dargestellt. Das Formwerkzeug besitzt einen Schichtaufbau mit einer Gesamtwandstärke von ca. 1 mm bis ca. 4 mm, vorzugsweise 1,5 mm. Der Schichtaufbau wird nachfolgend anhand der Figur näher beschrieben.

Die Formwerkzeugoberfläche des Formwerkzeugs wird aus einer Schicht aus Metall 1, mit einer Gesamtwandstärke von ca. 0,8 mm bis ca. 2 mm gebildet. In einer bevorzugten Ausführungsform beträgt die Wandstärke 1,5 mm. Eine Wandstärke von 0,9 bis 1,1 mm liegt in einem besonders bevorzugten Bereich. Die Metallschicht 1 wird üblicherweise in einem Galvanobad galvanisch abgeschieden. In einem alternativen Herstellverfahren kann die Metallschicht beim NVD-Verfahren (Nickel Vapour Deposition) chemisch abgelagert werden. Hierbei wird in ein Modell verwendet, auf welchem auf der Modelloberfläche die Metallschicht aufgalvanisiert bzw. gemäß dem alterantiven Verfahren chemisch abgelagert wird. Die Metallschicht kann auch aus mehreren galvanisierbaren oder chemisch abscheidbaren Schichten aus Metall ausgeführt sein. Als Material für die Metallschicht wird insbesondere Nickel oder Nickel Verbindungen verwendet.

Auf der Rückseite (d.h. der der Formwerkzeugoberfläche abgewandten Seite) der formgebenden Metallschicht 1 ist eine hitzebeständige, elektrisch isolierende Beschichtung 2 von ca. 0,005 mm bis ca. 0,5mm, vorzugsweise 0,05 mm aufgebracht. Diese elektrisch isolierende Beschichtung 2 zeichnet sich dadurch aus, dass sie eine hohe elektrische Durchschlagskraft bzw. hohe elektrische Durchschlagfestigkeit und ein hohes Wärmeleitvermögen bzw. hohe Wärmeleitfähigkeit aufweist. Als Material kann hierbei beispielsweise Bornitrid eingesetzt werden. Als weitere Materialien können Keramik, Emaille, Porzellan, und hochtemperaturbeständige Polymere verwendet werden. Diese elektrisch isolierende Beschichtung kann aufgesprüht, aufgestrichen oder unter Vakuum aufgedampft werden.

In einer bevorzugten Ausführung kann die elektrisch isolierende Beschichtung in einem Parylene Beschichtungsprozess aufgedampft werden. Nach dem Aufbringen dieser Schicht ist eine Sinter- bzw. Plasmabehandlung erforderlich, damit die Isoliermaterialien ausreagieren, bzw. Wasserbestandteile abgeben und die Haftung mit der Heizschicht gegeben ist.

Auf der elektrisch isolierenden Beschichtung 2 ist eine elektrische Flächenheizung angeordnet. Diese wird in den Bereichen angeordnet, welche beheizt werden sollen. Die elektrische Flächenheizung 3 umfasst eine Wandstärke von ca. 0,05 mm bis ca. 0,5 mm, vorzugsweise 0,15 mm. Die elektrische Flächenheizung 3 ist aus Carbon Nanotubes oder aus Carbongewebe ausgeführt. Eine entsprechende flächige Schicht aus den genannten Materialien kann aufgesprüht, aufgestrichen, aufkaschiert oder in einem Tauchbad hergestellt werden. Durch die genannten Herstellverfahren kann in unterschiedlichen Bereichen eine unterschiedliche Schichtdicke aufgebracht werden.

In einer alternativen Ausführungsform ist die elektrische Flächenheizung eine elektrische Widerstandsheizung aus Metall. In einer alternativen Ausführungsform ist die elektrische Flächenheizung eine elektrische Widerstandsheizung aus Metall, bei welcher die Widerstandsheizung aus aufgalvanisierten Heizfeldern besteht. Die Metallwiderstandsheizung, welche aufgalvanisiert ist, kann aus reinen Metallen bevorzugt Nickel oder Kupfer, aus Metallkombinationen oder aus Metallen mit Zusätzen bestehen. Bevorzugte Zusätze sind Carbon und/oder Carbon Nanotubes. Carbon und/oder Carbon Nanotubes werden direkt im Metall abgelagert. Die elektrische Flächenheizung ist in einer Stärke von 1 bis 3 mm herstellbar.

Die Formwerkzeugoberfläche bzw. Oberfläche des Formwerkzeuges kann hierbei in mehrere getrennte Heizzonen mit Bereichen einer elektrischen Flächenheizung 3 unterteilt sein. Dies hat den Vorteil, dass die Temperaturparametrisierung der Formoberfläche sehr genau austariert werden kann. Die entsprechende Einstellung erfolgt einmalig bei der Herstellung des Formwerkzeuges über die Anpassung der Schichtdicke der Carbon Heizbeschichtung. Die elektrische Flächenheizung 3 bzw. die einzelnen Heizzonen sind mit elektrischen Versorgungs- und Steuerleitungen versehen. Diese sind der Einfachheit halber zeichnerisch nicht dargestellt.

Die Temperatursteuerung bzw. Temperaturregelung der einzelnen Heizzonen erfolgt über Anpassung der Spannung bzw. Stromstärke und kann somit stufenlos von Raumtemperatur bis zur Maximaltemperatur geregelt werden. Die Heizfelder können dabei individuell ansteuerbar ausgeführt sein. Dies ermöglicht eine gleichmäßige Wärmeverteilung über die gesamte Werkzeugoberfläche. Die Anpassung erfolgt dabei in Abhängigkeit der Geometrie der entsprechenden Oberflächenbereiche des Formwerkzeugs.

Um die Grenzwerte für Kleinspannung, die in der IEC 60449 festgelegt sind, nicht zu überschreiten, können die einzelnen Abschnitte der elektrischen Flächenheizung in einer Parallelschaltung miteinander verschaltet werden. Dies führt zu sicheren Arbeitsbedingungen bei dem Rotationssinterverfahren.

Die maximale mögliche Heiztemperatur für das Formwerkzeug (Galvanoform) mit integrierter elektrischer Flächenheizung beträgt ca. 500°C.

Wie es weiterhin aus der Schnittdarstellung zu erkennen ist, ist auf der elektrischen Flächenheizung 3 bzw. auf den einzelnen Abschnitten von elektrischen Flächenheizungen 3 eine elektrisch isolierende Beschichtung 4 von ca. 0,005 mm bis ca. 0,5mm, vorzugsweise 0,1 mm aufgebracht. Diese elektrisch isolierende Beschichtung 4 zeichnet sich dadurch aus, dass sie eine hohe elektrische Durchschlagskraft bzw. hohe elektrische Durchschlagfestigkeit und ein hohes Wärmeleitvermögen bzw. hohe Wärmeleitfähigkeit aufweist. Als Material kann hierbei beispielsweise Bornitrid eingesetzt werden.

Die komplette elektrische Flächenheizung 3 inkl. aller Versorgungs- und Steuerleitungen weist demnach zwischen zwei elektrisch isolierenden Beschichtungen (2,4) angeordnet und somit elektrisch isoliert eingebettet.

Auf der elektrisch isolierenden Beschichtung ist eine weitere Schicht 5 aus Metall aufgebracht, die eine Schichtdicke von ca. 0,1 mm bis ca. 1 mm, vorzugsweise 0,4 mm aufweist. Die Metallschicht wird vorzugsweise in einem Galvanobad auf galvanisiert.

Bei dem abschließenden Schritt des Aufbringens der Metallschicht 5 wird die komplette elektrische Flächenheizung 3 inkl. der elektrischen Versorgungs- und Steuerleitungen luftdicht gekapselt. Dies bietet insbesondere einen Schutz gegen äußere Einflüsse, wie z.B. mechanische Beschädigungen, aggressive Reinigungsmittel. Des Weiteren schützt die luftdichte Kapselung der elektrischen Flächenheizung vor einer "Aufkohlung" der Carbon Heizbeschichtung.

Die galvanische Metallschicht (5) kann in einer bevorzugten Ausführungsform auch durch eine oder mehrere hitzebeständige Metall oder nicht Metallschichten ausgeführt werden.

## Patentansprüche

1. Beheizbares, Formwerkzeug, insbesondere beheizbares galvanisch abgeschiedenes Formwerkzeug, welche den folgenden Schichtaufbau umfasst, eine erste metallische Schicht (1), die die formgebende Oberflächenschicht bildet, mindestens eine zwischen zwei elektrisch isolierenden Schichten (2, 4) angeordnete elektrisch ansteuerbare Flächenheizung (3), sowie eine die Außenfläche des Formwerkzeugs bildende zweite metallische Schicht (5), wobei die erste und zweite metallische Schicht (1, 5) derart ausgeführt und angeordnet sind, dass sie die mindestens eine elektrisch ansteuerbare Flächenheizung (3) luftdicht einschließen, wobei die gesamte Wandstärke der Schichtenstruktur zwischen 1 mm und 4 mm liegt,
**dadurch gekennzeichnet, dass**
die elektrisch isolierende Beschichtung (2,4) eine hohe elektrische Durchschlagsfestigkeit, eine hohe Hitzebeständigkeit und eine hohe Wärmeleitfähigkeit aufweist, wobei die elektrisch isolierende Beschichtung aus Parylene und/oder Bornitrid besteht.

2. Beheizbares Formwerkzeug nach Anspruch 1, wobei die Flächenheizung eine Heizbeschichtung, eine Heizmatte oder eine Heizfolie ist.

3. Beheizbares Formwerkzeug nach einem der vorangehenden Ansprüche, wobei die elektrisch isolierende Beschichtung (2, 4) aus mehreren unterschiedlichen Einzelschichten besteht.

4. Beheizbares Formwerkzeug nach einem der vorhergehenden Ansprüche, wobei die erste und zweite Metallschicht eine galvanische Metallschicht ist und vorzugsweise aus Nickel oder einer Nickel Verbindung besteht und die luftdichte Abkapselung der mindestens einen elektrischen Flächenheizung beim Aufgalvanisieren der zweiten Schicht erfolgt.

5. Beheizbares Formwerkzeug nach einem der vorangehenden Ansprüche, wobei die mindestens eine Flächenheizung eine Schichtdicke von ca. 0,05 mm bis ca. 0,5 mm, vorzugsweise 0,15 mm aufweist.

6. Beheizbares Formwerkzeug nach einem der vorangehenden Ansprüche, wobei die Flächenheizung (3) eine Carbon Nanotubes Heizbeschichtung, eine Carbonfasermatte, eine Carbonfolie oder eine Metallwiderstandsheizschicht ist.

7. Beheizbares Formwerkzeug nach einem der vorangehenden Ansprüche, wobei die Schichtdicke der elektrischen Flächenheizung in vorbestimmten Bereichen des Formwerkzeugs unterschiedlich dick ausgestaltet sein kann.

8. Beheizbares Formwerkzeug nach einem der vorangehenden Ansprüche, wobei eine Vielzahl von elektrisch ansteuerbarer Flächenheizungen angeordnet ist, die jeweils einzeln ansteuerbar ausgeführt sind.

9. Beheizbares Formwerkzeug nach einem der vorhergehenden Ansprüche, wobei die Vielzahl elektrisch ansteuerbarer Flächenheizungen in einer Parallelschaltung oder Reihenschaltung oder einer Kombination von Parallel und Reihenschaltung miteinander verschaltet sind.

10. Verfahren zum Herstellen eines beheizbaren, Formwerkzeugs, mit den Schritten:
a) Herstellen einer ersten metallischen Schicht (1), die die formgebende Oberflächenschicht bildet
b) Aufbringen einer ersten isolierenden Schicht (2) auf der der Oberflächenschicht abgewandten Seite der metallischen Schicht (1)
c) Aufbringen einer elektrisch ansteuerbaren Flächenheizung (3) auf der ersten isolierenden Schicht (2)
d) Aufbringen einer zweiten isolierenden Schicht (4) auf der Flächenheizung (3)
e) Aufbringen einer zweiten metallischen Schicht (5) in einem Galvanobad, die Außenfläche des Formwerkzeugs bildet, wobei diese zweite Schicht (5) derart gebildet wird, dass die erste und zweite metallische Schicht (1,5) die mindestens eine elektrisch ansteuerbare Flächenheizung (3) luftdicht einschließen,
wobei die Schichtenstruktur, bestehend aus der ersten metallischen Schicht (1), der ersten isolierenden Schicht (2), der Flächenheizung (3), der zweiten isolierenden Schicht (4) und der zweiten metallischen Schicht (5), eine gesamte Wandstärke zwischen 1 mm und 4 mm besitzt,
**dadurch gekennzeichnet, dass**
die elektrisch isolierende Beschichtung durch einen Parylene Beschichtungsprozess aufgedampft wird, wobei in einem anschließenden Schritt eine Sinter- bzw. Plasmabehandlung erfolgt.

11. Verfahren zum Herstellen eines Formwerkzeugs nach Anspruch 10, wobei die metallischen Schichten (1,5) in einem Galvanobad abgeschieden wird oder beim Nickel Vapour Deposition Verfahren, chemisch abgelagert werden.

12. Verfahren zum Herstellen eines Formwerkzeugs nach einem der Ansprüche 10 oder 11, wobei die elektrisch isolierende Beschichtung (2,4) aufgesprüht, aufgestrichen oder unter Vakuum aufgedampft wird.

13. Verfahren zum Herstellen eines Formwerkzeugs nach einem der Ansprüche 10-12, wobei die Flächenheizung (3) mehrere getrennt ansteuerbare Heizzonen umfasst, die mit unterschiedlichen Schichtdicken aufgebracht werden.

## Claims

1. Heatable moulding tool, in particular, heatable electroplated moulding tool, which comprises the following layer structure: a first metallic layer (1), which forms the shaping surface layer, at least one electrically controllable surface heater (3) arranged between two electrically insulating layers (2, 4), and a second metallic layer (5) forming the outer surface of the moulding tool, wherein the first and second metallic layers (1, 5) are configured and arranged so as to enclose the at least one electrically controllable panel heater (3) in an airtight manner, wherein the total wall thickness of the layer structure is between 1 mm and 4 mm,
**characterised in that**
the electrically insulating coating (2, 4) has a high dielectric strength, a high heat resistance and a high thermal conductivity, wherein the electrically insulating coating consists of Parylene and/or boron nitride.

2. Heatable moulding tool according to claim 1, wherein the surface heater is a heating coating, a heating pad or a heating film.

3. Heatable moulding tool according to one of the preceding claims, wherein the electrically insulating coating (2, 4) consists of a plurality of different individuals layers.

4. Heatable moulding tool according to one of the preceding claims, wherein the first and second metal layers are galvanic metal layers and, preferably, consist of nickel or a nickel compound, and the airtight encapsulation of the at least one electrical surface heater occurs during electrodeposition of the second layer.

5. Heatable moulding tool according to one of the preceding claims, wherein the at least one surface heater has a layer thickness of approximately 0.05 mm to approximately 0.5 mm, preferably 0.15 mm.

6. Heatable moulding tool according to one of the preceding claims, wherein the surface heater (3) is a carbon nanotube heatable coating, a carbon-fibre pad, a carbon film or a metal resistance heating layer.

7. Heatable moulding tool according to one of the preceding claims, wherein the layer thickness of the electrical surface heater in predefined regions of the moulding tool can be designed with different thickness.

8. Heatable moulding tool according to one of the preceding claims, wherein a plurality of electrically controllable surface heaters is arranged which can be configured in an individually controllable manner.

9. Heatable moulding tool according to one of the preceding claims, wherein the plurality of electrically controllable surface heaters are connected to each other in parallel or series or a combination of parallel or series.

10. Method for producing a heatable moulding tool, comprising the steps:
a) producing a first metallic layer (1), which forms the shaping surface layer
b) applying a first insulating layer (2) to the side of the metallic layer (1) which faces away from the surface layer
c) applying an electrically controllable surface heater (3) on the first insulating layer (2)
d) applying a second insulating layer (4) on the surface heater (3)
e) applying a second metallic layer (5) in an electroplating bath, which layer forms the outer surface of the moulding tool, wherein said second layer (5) is formed such that the first and second metallic layers (1, 5) enclose at least one electrically controllable surface heater (3) in an air-tight manner,
wherein the layer structure, consisting of the first metallic layer (1), the first insulating layer (2), the surface heater (3), the second insulating layer (4) and the second metallic layer (5), has a total wall thickness between 1 mm and 4 mm;
**characterised in that**
the electrically insulating coating is vapour-deposited through a Parylene coating process, wherein in a subsequent step a sintering or plasma treatment occurs.

11. Method for producing a moulding tool according to claim 10, wherein the metallic layers (1, 5) are deposited in an electroplating bath or chemically deposited using the nickel vapour deposition method.

12. Method for producing a moulding tool according to one of the claims 10 or 11, wherein the electrically insulating coating (2, 4) is sprayed on, brushed on or vapour-deposited under vacuum.

13. Method for producing a moulding tool according to one of claims 10-12, wherein the surface heater (3) comprises a plurality of separately controllable heating zones which are applied with different layer thicknesses.

## Revendications

1. Outil de formage pouvant être chauffé, notamment outil de formage déposé par voie galvanique pouvant être chauffé, comprenant la structure stratifiée suivante, une première couche métallique (1), qui forme la couche de surface de mise en forme, au moins un chauffage de surface (3) à commande électrique disposé entre deux couches électriquement isolantes (2, 4), ainsi qu'une deuxième couche métallique (5) formant la surface externe de l'outil de formage, où les première et seconde couches métalliques (1, 5) sont conçues et disposées de sorte qu'elles entourent de manière étanche à l'air d'au moins un chauffage de surface (3) à commande électrique, avec une épaisseur totale de paroi de la structure en couches comprise entre 1 mm et 4 mm,
**caractérisé en ce que**
le revêtement électriquement isolant (2,4) présente une rigidité diélectrique élevée, une résistance à la chaleur élevée et une conductivité thermique élevée, et avec un revêtement électriquement isolant constitué de parylène et/ou de nitrure de bore.

2. Outil de formage pouvant être chauffé selon la revendication 1, où le chauffage de surface est un revêtement chauffant, un tapis chauffant ou une feuille de chauffage.

3. Outil de formage pouvant être chauffé selon une des revendications précédentes, où le revêtement électriquement isolant (2, 4) est constitué de plusieurs couches individuelles différentes.

4. Outil de formage pouvant être chauffé selon une des revendications précédentes, où les première et seconde couches métalliques sont des couches métalliques galvaniques et constituées de préférence de nickel ou d'un composé de nickel et l'encapsulation étanche à l'air d'au moins un chauffage de surface électrique s'effectue par galvanisation de la seconde couche.

5. Outil de formage pouvant être chauffé selon une des revendications précédentes, où au moins un chauffage de surface présente une épaisseur de couche d'environ 0,05 mm à environ 0,5 mm, de préférence de 0,15 mm.

6. Outil de formage pouvant être chauffé selon une des revendications précédentes, où le chauffage de surface (3) est un revêtement chauffant à nanotube de carbone, un tapis de fibres de carbone, une feuille de carbone ou une couche chauffante à résistance métallique.

7. Outil de formage pouvant être chauffé selon une des revendications précédentes, où l'épaisseur de couche du chauffage de surface électrique peut être conçue avec des épaisseurs différentes dans des régions prédéfinies de l'outil de formage.

8. Outil de formage pouvant être chauffé selon une des revendications précédentes, où une pluralité de chauffages de surfaces à commande électrique sont agencés, conçus chacun pour être commandés individuellement.

9. Outil de formage pouvant être chauffé selon une des revendications précédentes, où la pluralité de chauffages de surface à commande électrique sont interconnectés dans un circuit en parallèle ou un circuit en série ou en une combinaison de circuits en parallèle et en série les uns avec les autres.

10. Procédé de fabrication d'un outil de formage pouvant être chauffé, comprenant les étapes suivantes :
a) fabrication d'une première couche métallique (1), qui forme la couche de surface de mise en forme
b) application d'une première couche isolante (2) sur le côté opposé à la couche de surface de la couche métallique (1)
c) application d'un chauffage de surface (3) à commande électrique sur la première couche isolante (2)
d) application d'une seconde couche isolante 4) sur le chauffage de surface (3)
e) application d'une seconde couche métallique (5) dans un bain galvanique, qui forme la surface externe de l'outil de formage, où cette seconde couche (5) est formée de sorte que les première et seconde couches métalliques (1,5) entourent de manière étanche à l'air d'au moins un chauffage de surface (3) à commande électrique,
où la structure en couches, constituée de la première couche métallique (1), de la première couche isolante (2), du chauffage de surface (3), de la seconde couche isolante (4) et de la seconde couche métallique (5), présente une épaisseur de paroi totale comprise entre 1 mm et 4 mm,
**caractérisé en ce que**
le revêtement électriquement isolant est appliqué par métallisation par un processus de revêtement de parylène, où, dans une étape ultérieure, un traitement de frittage ou au plasma est effectué.

11. Procédé de fabrication d'un outil de formage selon la revendication 10, où les couches métalliques (1,5) sont déposées dans un bain galvanique ou déposées par un procédé de dépôt en phase vapeur de nickel de manière chimique.

12. Procédé de fabrication d'un outil de formage selon une des revendications 10 ou 11, où le revêtement électriquement isolant (2,4) est pulvérisé, appliqué ou déposé sous vide.

13. Procédé de fabrication d'un outil de formage selon une des revendications 10-12, où le chauffage de surface (3) comprend plusieurs zones de chauffage à commande séparée, qui sont appliquées avec des épaisseurs de couche différentes.
